(19)

Europäisches
Patentamt
European
Patent Office
Office européen
des brevets

(11) **EP 3 958 180 A1**

(12) **EUROPEAN PATENT APPLICATION**

(43) Date of publication:
**23.02.2022 Bulletin 2022/08**

(21) Application number: **20191767.1**

(22) Date of filing: **19.08.2020**

(51) International Patent Classification (IPC):
**G06N 3/04** *(2006.01)*          **G06F 30/27** *(2020.01)*
**G06N 3/08** *(2006.01)*          **G06N 5/02** *(2006.01)*
**B60K 6/00** *(2006.01)*

(52) Cooperative Patent Classification (CPC):
**G06N 3/0454; B60W 50/04; G06F 30/27;
G06N 3/084; G06N 5/025; B60W 2050/0088**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Aktiengesellschaft
80333 München (DE)**

(72) Inventors:
• **JOBLIN, Mitchell
  81825 München (DE)**
• **NICOLAI, Mike
  3360 Bierbeek (BE)**
• **RINGSQUANDL, Martin
  83022 Rosenheim (DE)**

(54) **METHOD FOR DETERMINING AN INDICATOR OF A TECHNICAL SYSTEM, DETERMINATION UNIT AND CONSTRUCTION SYSTEM**

(57)    The invention relates to a method for determining an indicator (KPI) describing a performance of at least some components of a technical system (HV),
said components having properties that enable a relation between two or more components,
whereby to at least some of the components an attribute (ATT) is assigned,
said method having the following steps:
-Representing (A) the technical system (HV)by a data architecture graph (DA) having nodes connected by edges, said nodes representing components or group of components, or properties of components or group of components of the technical system, and
said edges representing relations between components or properties of components of the technical system;
-Using (B) the data architecture graph (DA) as input for a first graph convolutional neural network (GCNN1) in order to create encoded data ($H^{(1)}$)in which a relation between nodes that are directly connected by an edge is encoded, said first graph convolutional neural network (GCNN1) being trained by a machine learning model operating on the data architecture graph;
-Combining (C) the encoded data with at least some of the attributes (ATT) by which pooled graph encoded data (PGED) are obtained;
-Predict (D) the indicator (KPI) by using these combined data as input for a dense layer neural network (DL).

FIG 2

EP 3 958 180 A1

## Description

**Field of the Invention**

The invention relates to a method for determining an indicator of a technical system a determination unit and a construction system. Further, the invention relates to a computer program product and computer readable storage media.

**Background**

In industrial manufacturing engineers are often tasked with the problem of finding an optimal design for a complex system, e.g. a hybrid car where suitable combinations of components have to be found. An optimal design can be defined by one or more key performance indicators (KPI) which describe the properties that are of interest.

For example, in automotive and aerospace product design, part of the design process is to identify a subset of components that are available for use and connecting the components appropriately to achieve a valid design, i.e. a design that will work under real conditions.

However, one challenge in finding a reasonably good or an optimal design is attributed to the extremely large design space, i.e. the large number of possible combinations of the components. Thus, many millions or even billions of designs are technically valid and will work in reality, but they are not ideal with respect to one or more KPIs. E.g. a car may be very robust against impacts from the front side, but not from the sides, the aerodynamic resistance might be hampered etc. Hence, the design process is relied upon the engineer's experience or domain knowledge to make decisions about how to improve a design towards a desired goal.

The proposed design can then be simulated to determine how well that design performs with respect to the KPIs which are of interest.

A disadvantage is that this simulation process can take a very long time to complete and thus slows down the design workflow.

If a fixed time window is set for the design process, the engineer uses currently two possibilities, namely scaling up the computing infrastructure, e.g. using parallel processing techniques, and reducing the search space for optimal designs. The latter is particularly based on the experiences of the engineers who often use their domain knowledge to construct a subset of potential designs that they deem most promising.

Still, this may result in that a large number of design possibilities is not explored or, in other words, the design space that can be explored is reduced and consequently optimal designs are found less frequently. This may result in the production of a vehicle that has e.g. worse fuel consumption or acceleration characteristics than it would be possible with today's available components.

It is one object of the invention to offer a possibility for accelerating the design process and thus providing the possibility to improve the design process.

**Brief Summary of the Invention**

This is solved by what is disclosed in the independent claims. Advantageous embodiments are subject of the dependent claims.

The invention relates to a method by which an indicator is determined, which describes a performance of at least some components of a technical system, e.g. a hybrid car, an airplane or a production line. The components have properties that enable a relation between two or more components, e.g. they can be electrically or mechanically connected. Some of the components have further an attribute. For example, an attribute can be categorical, e.g. denoting the type, e.g. motor. An attribute can also be numeric, e.g. size or power of a motor. In particular, the numerical value can be continuous.

The method comprises the following steps: Representing the technical system by a data architecture graph having nodes connected by edges. The nodes represent components or group of components or properties of components or group of components of the technical system. E.g. a node can describe the component type "motor" or "battery" or may denote a port for an electrical connection that is available at the battery.

Nodes are connected by edges representing relations between components or properties of components of the technical system. E.g. it shows whether there is an electrical connection between a specific battery and a motor and optionally attributes provide further information on the connection.

This data architecture graph is used as input for a first graph convolutional neural network in order to create encoded data which encode a relation between nodes that are directly connected by an edge.

These encoded data are combined with at least some of the numerical attributes by which pooled graph encoded data are obtained.

Based on these the desired indicator is derived by using these combined data as input for a dense layer neural network, which may comprise one or more layers.

The advantage of the claimed method is in particular that by the described graphical representation multiple relations between components of the technical system can be captured, which is not possible with a table as used commonly for technical descriptions. By use of a graph convolutional network correlations between direct neighbored nodes and more distant nodes can be considered. By use of attributes and by denoting the node with a node type a permutation invariant representation of the technical system can be achieved, which allows an effective training of the neural network.

A further advantage is that by the proposed method constitutes an inductive learning algorithm for graph structured data. Most state-of-the-art learning algorithms only function transductively, i.e. reason from specific cases, e.g. training cases, to other specific cases, e.g. test cases. In contrast, by inductive learning algorithms general rules can be derived, which can then be applied to e.g. specific test cases. In other words, by the proposed method, properties of indicators occurring in specific test cases can be predicted, even if the specific test case has not been considered in the learning process.

The invention further relates to determination unit for deriving an indicator, a construction unit and a computer program product and storage media for such computer program product.

**Brief description of the drawings:**

Further embodiments, features, and advantages of the present invention will become apparent from the subsequent description and dependent claims, taken in conjunction with the accompanying drawings of which show:

Fig.1a an example of a graphical representation or knowledge graph of a data structure used for a subset of components of an electric vehicle, comprising various components and attributes having numerical values for one or more components.

Fig. 1b an example of a table with numerical attributes for the motors used in the architecture of Fig. 1a.

Fig. 2 provides a schematic overview of a workflow for an advantageous embodiment for deriving indicators that describe the performance of a system.

Fig.3 a and 3 b show an example of isomorphic data structures

Fig.4 shows a schematic view of a determination unit which can be used to derive a performance indicator.

**FIG 1**

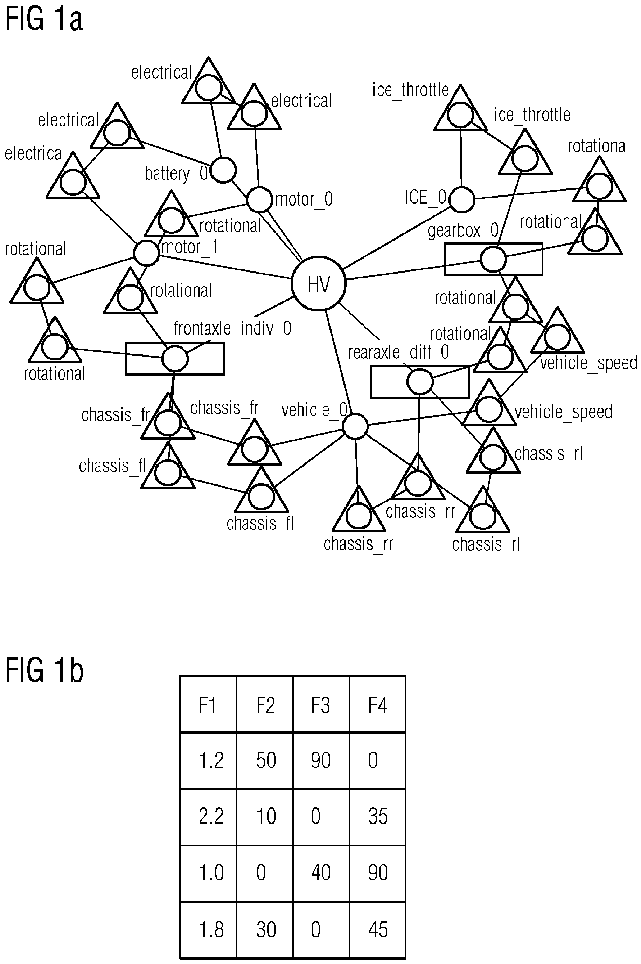

In Figure 1a a schematic drawing of a section of a data architecture for a specific vehicle is depicted. This graphical representation of the data structure is denoted also as "knowledge graph". The data structure is a formal representation of the engineering design which comprises heterogenous information about components, component properties and how and which of the components are related, thus is multire-lational. Thus, the shown data architecture can be derived from an engineering specification. This is what is usually provided by the customer for whom a specific design, e.g. of a hybrid car, is made. From this specification the nodes and their attributes, the type of the attribute and the edges, i.e. source and target node, can be extracted. Thus, a list of nodes representing the components with their type can be extracted. Therefrom, by using graph regressors an architecture can be derived which serves as input data of graph convolutional neuronal network (GCNN).

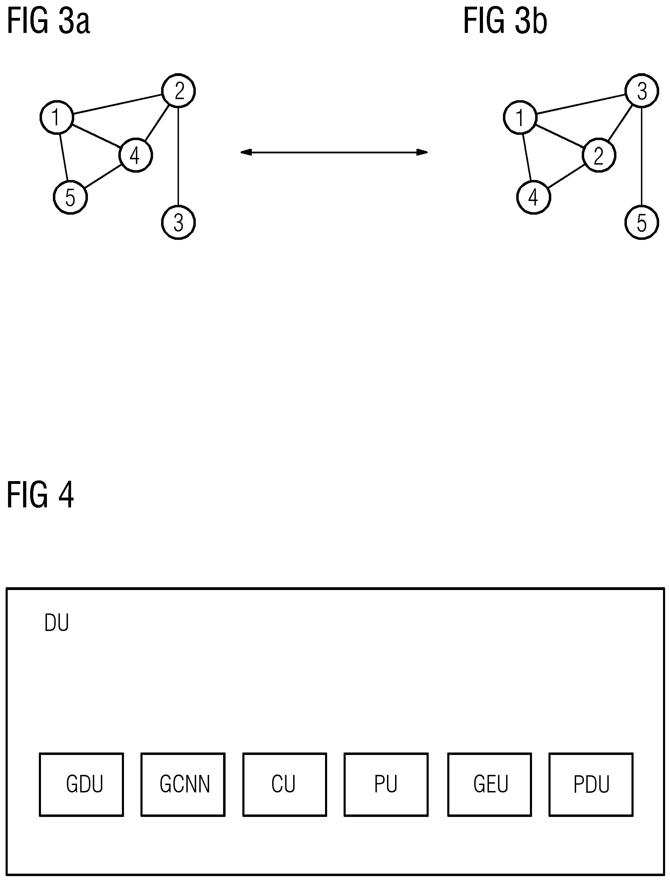

The usual representation of an engineering design is a table. The disadvantage of tables is that complex relations thus as multi relations cannot be captured. Another disadvantage is that a table, if it should be used as input data, needs always to have the same structure, e.g. the same number properties regarded which might e.g. be contained in a column. In this case the number of columns needs then to be the same. Hence, the graphical representation of the technical system, e.g. the hybrid car, is much more flexible, e.g. if the number and types of components vary, do not require an ordering which would lead to permutation variant representations (see Fig.3) and moreover can contain the plurality of relations that exists, e.g. the electrical connection to the first electric motor motor_0 and to the second electric motor motor_1. For example, these electrical connections are different, because due to a different maximum current of the two electric motors, the current is differently limited in the two connections. Also due to a different position in the car, the cable length to the two motors differs which leads to a different capacity and inductivity which influence the current behavior over time especially in a start phase. In the graph this information can be easily captured by representing the components "electric motors" and the "properties" of their connection as nodes which are connected by edges. This will be explained further below:

In the graphical representation there are nodes, which describe components, assets and ports and which are identified by a node type. The root or central node or architecture node HV describes a specific architecture.

For a planned hybrid vehicle, various data architectures can be created so that different embodiments of the vehicle are described which differ e.g. in one or more components.

The specific hybrid vehicle HV has several components, e.g. motor 0 MO and motor 1 M1, battery 0 B0, vehicle chassis V0 and internal combustion machine ICE_0.

In Fig. 1a these components are depicted with a circle and are directly connected by an edge to the root of the graph representing the hybrid vehicle HV. Optionally, there are some components that are not varied during the current task, e.g. number of tyres, axles, gearbox etc. In Fig. 1 such invariable components or "assets" are depicted with a square.

In the following invariable components or assets and components are referred to as "components".

A component has one or more ports across which a relation to other components is established, e.g. electrically, mechanically, e.g. rotationally or via the chassis, via a specific throttle of the internal combustion machine etc. These possible relations via the ports are depicted by a triangle and form again nodes in the data topology.

A port represents a facility for an e.g. mechanical or electrical interaction. Each edge represents a correlation between the two connected components, e.g. a mechanical coupling constant between two chassis parts or torque coupler between an internal combustion engine and a front or rear axle, an electromagnetic coupling between components of an electric motor.

These relations may lead via one edge from one component to another. This is depicted in Fig. 1a between motor_1 and motor_0 with one edge via their port for rotational interactions.

The components, invariable components or assets, and ports constitute nodes of a data topology centered around a root node denoting a specific architecture of the technical system, e.g. the hybrid vehicle. The nodes of the data topology are connected by edges denoting a correlation between two nodes.

This correlation can be unidirectional or bidirectional.

An attribute is assigned to at least some components. This attribute can be e.g. the number of coil windings of an electric motor, the cylinder size of an internal combustion engine ICE, e.g. a motor driven by fuel. In Fig. 1b a table with attributes F1-F4 is depicted. In each row the numerical values of these attributes for different components, e.g. electric motors are listed.

According to an example the large configuration space the engineer is working on is the combination of an internal combustion engine ICE and an electric motor for a hybrid car. The engineering specification for the hybrid car provides in a "large configuration space" of the overall design that an internal combustion engine with 3 variants having 1.51, 2.01 and 2.41 cylinder capacity and an electric motor with 3 variants having (96kW,250Nm), (50kW,200Nm) and (33kW, 210Nm) is foreseen. For the variant specification of e.g. the component "electric motor" it is provided as property, that the number of motors or multiplicity varies between 1 and 4. It is further provided that for a specific electric motor of the electric motors 1 to 4 a port is provided for electrical interaction and another port for rotational interaction. This information is encoded in the data topology containing the nodes and edges. However, for the architecture of the hybrid vehicle also the numerical values denoting motor size and power need to be considered. These are the attributes assigned to at least some of the components.

The task of the engineer is now to find a combination of ICE and electric motor that optimizes an important indicator, a so-called key performance indicator or KPI, of the overall system, which is in this example acceleration time vs fuel consumption. This optimization can be done by using physical simulations, which however, as set out before, requires a significant amount of time.

According to the here described invention and embodiments thereof, by using a neural network applied on the graphical representation of the data architecture as input data the KPI as output data can be achieved immediately, i.e. requiring much less time than the simulation.

In order that this graphical representation or knowledge graph is suitable for machine learning, it must be provided with a sufficiently rich semantic representation of the design otherwise the prediction performance in a machine learning model would otherwise be very low. This is achieved by a description by a data topology as described above having nodes with type information, e.g. "battery", "motor", "electrical port" etc., links with properties and further assigning attributes, in particular numerical attributes to some nodes.

As a further example, a gearbox, which is depicted as a node in Fig. 1a has as attribute a mass of 40 kg. It has several mechanical connections, each denoted a mechanical port of the gearbox from which an edge establishes a connection to another component, e.g. the internal combustion engine ICE_0.

The gearbox may further have an electrical connection, which is not depicted in Fig. 1a, denoted by an electrical port from which an edge may establish a connection to a neighboring node.

From the architecture topology and the attributes input data for a graph convolutional network are derived. The output of the GCNN is a matrix whose dimensions depend on the number of nodes and the number of latent dimensions of the GCNN.

## Fig.2

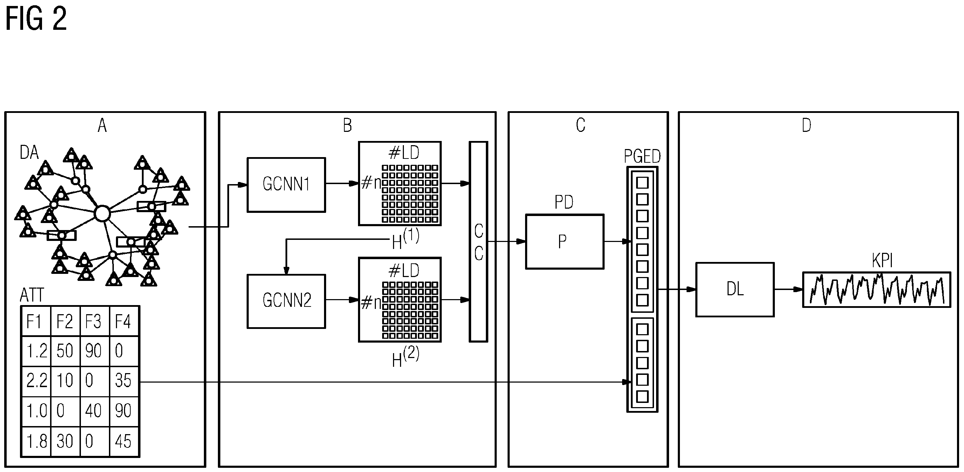

In Fig.2 a schematic system architecture or exemplary workflow for a method deriving indicators of an exemplary hybrid vehicle architecture is shown.

In step A input data are created from the technical description of the system, which is in this example a subset of a hybrid vehicle architecture. The depicted subset focuses on the combination of electric motor and internal combustion engine ICE. The data architecture DA derived from the technical description comprises nodes with attributes ATT and edges connecting the nodes and serves as input data for step B.

A table with numerical attributes ATT is depicted at the bottom. The numeric attributes can be any continuous variables that describe some property of one or more components of the system.

In step B a representation of the nodes of the data architecture and their relations to neighbored nodes is obtained by feeding the input data in graph convolutional neural networks (GCNN).

The input data are $H^{(0)}$, which is a representation of the node features and the link structure of the data architecture described by matrix $\tilde{A}$, e.g. an adjacency matrix, supplied to a first graph convolutional neural network GCNN1. In this first graph convolutional network features of one hop distant nodes are encoded in the representation of one node. By reiterating this process more and more distant information will be considered for a specific node. The first graph convolutional neural network GCNN1 may comprise a single convolutional layer. Alternatively, more complex operations may be possible, e.g. also including other layers, e.g. further convolutional layers or other types of layers.

The output thereof, which is a matrix $H^{(1)}$ with dimensions depending on the number of nodes #n of the data architecture DA and the number of latent dimensions #LD of the first graph convolutional neural network GCNN1 serves as input for a second graph convolutional neural network GCNN2, which is in particular different from the first graph convolutional neural network GCNN1, e.g. has been trained in a different way.

The values of matrix $H^{(1)}$reflect first order correlations between two nodes, i.e. with one edge in between. Thus, in addition to node features, first order correlations are encoded in this matrix $H^{(1)}$. This can be important e.g. for investigation or deriving indicators for the components which are directly connected to the architecture node HV. As explained before, a first order correlation has an edge leading directly from source node to target node, a second order correlation has an edge leading from the source node via a first edge to an intermittent code and via a second edge to the target node, etc.

By using $H^{(1)}$ as input for the second graph convolutional neural network GCNN2, second order correlations between two nodes, i.e. the nodes having a node in between, thus via two edges are considered in the output $H^{(2)}$ which is a matrix with dimensions number of nodes #n* number #LD of latent dimensions of the graph convolutional neural network. $H^{(2)}$ encodes node features and information from nodes one and two hops distant from the considered node. This matrix $H^{(2)}$ can be especially important if relations between the first battery battery_0 and the first electric motor motor_0 are being investigated so that indicators for their behavior can be derived.

Experiments have shown that considering first order and second order relations, i.e. considering relations with nodes one hop or two hop away, lead to good results, i.e. the indicators derived reflect the reality very well. Depending on the data architecture, in other embodiments also higher order correlations are considered. The usefulness depends e.g. on the strength of the correlation between the nodes or the number of connections between a nodes and other nodes, because if going to higher order, more distant relations are being examined whereas information regarding the node features and from closer nodes is being smoothed out.

According to an advantageous embodiment the convolutional operator used in the GCNN is

$$H^{(l+1)} = \sigma(\widetilde{D}^{-1/2}\widetilde{A}\widetilde{D}^{-1/2}H^{(l)}W^{(l)})$$

wherein H is the representation of the nodes. 1 is a running variable denoting the number of latent dimensions in the graph convolutional neural network or the convolutional layer of the graph convolutional network. For 1=0, $H^{(0)}$ represents node features, e.g. the type which might be e.g. "component" or the number and type of ports. H is iteratively updated and then represents for values 1>0 also relations between the nodes.

$\sigma$ is a sigmoid function which is used as an activation function of the GCNN.

The matrix $\widetilde{D}^{-1}$ is used for normalization and can be derived from the input and a diagonal matrix.

$\widetilde{A}$ is a matrix reflecting the topology of the data structure. E.g. $\widetilde{A}$ is an adjacency matrix which describes the connections between one node and another node for all nodes in the graphical representation, hence it represents essentially the link structure. $W^{(l)}$ is a parameter or weight denoting the strength of a connection between units in the neural network. The advantage of this convolutional operators is its basic form. The aggregation, i.e. gathering of information relevant for one specific node, is based on mean values.

Alternatively, other convolutional operators can be used that are tailored for a specific problem, e.g. for a description of vibrations in the chassis or also for a process where gases or liquids or piece good are produced by various transformation along a production line. In some cases effects far away from one component might have a strong impact, whereas in other cases only specific elements or nearby elements have any impact. The aggregation, i.e. the "concentration" of information to one point needs to be different in these cases and hence different convolutional operators are to be used.

**Fig. 3**

For the machine learning it is important that identical or isomorphic structures do not lead to different input information. The advantage of applying the proposed graph convolutional formulation is that it is permutation invariant, as long as the node features are not encoded with the node ID. This is overcome by using the node type, e.g. motor, battery, etc. Then e.g. in matrix $H^{(0)}$all features of e.g. node 1 would be grouped together in a column, but it would not be required e.g. that it is column 1.

As said before, from the data topology or structure a sort of adjacency matrix $\widetilde{A}$ describing the link structure of the data architecture is derived and enters as input value the GCNN. When deriving a matrix from the data structure a numbering of nodes has to be introduced in order to put e.g. connections starting from node 1 to other nodes in row 1 and connections leading to node 1 in column 1 and so forth for columns 2, 3, 4 and 5. If the numbering would be changed, the result would be a different representation, i.e. a different matrix. In other words, by permutations different matrixes are obtained which describe the same data structure. This fact hampers the machine learning process, because all the possible permutations which can be a high number would have to be used as training data. Therefore permutation invariant representation of the data structure are needed.

To obtain such a permutation invariant representation of the data structure, the attributes of each node are used. By adding the attributes to individual nodes, they are made different from each other so that they are not exchangeable anymore. Then, for two isomorphic designs, even if the node or-derings are different, the machine learning model recognizes the designs as identical since the graph convolutions are designed to be permutation invariant.

In Fig. 3a and 3b two node structures are depicted. As said, if such a node structure is represented by a matrix, an ordering has to be given to the nodes, e.g. each node is given a number. The node structures shown in Figure 3a and 3b are isomorphic, i.e. unambiguously reversible, just the nodes are numbered differently. By adding the attributes a structure as shown in Fig. 3 a and b is not any more represented by the same matrix as the structure in Fig. 3b, because the nodes are not interchangeable any more, e.g. node 5 is not the same as node 3, because it has e.g. different features, e.g. node type, attributes, ports etc.

**Further Fig. 2**

The node representations $H^{(1)}$ and $H^{(2)}$ thus represent the structural identity of each node by encoding adjacency information. The node representations $H^{(1)}$ and $H^{(2)}$ are concatenated CC and thus concatenated data are obtained. For example the two matrices $H^{(1)}$ and $H^{(2)}$ are stacked, the concatenated data is then a matrix having the number of columns of $H^{(1)}$ plus the number of columns of $H^{(2)}$. So, the concatenated data's dimension depend on the original number of nodes in the data architecture, the number of latent dimensions of the first graph neural network GCNN1 and the number of dimensions of the second graph neural network GCNN2, and up to which order correlations are considered, i.e. how many matrixes $H^{(1)}$ are appended. Using the combined data in step C a summarizing takes place.

For further processing it is advantageous that the number of dimensions is not to high and/or that the number of dimensions has a predefined value.

In order to shrink the number of dimensions, e.g. to a predefined size, a pooling P is applied on the data. Thus, by the pooling P the node representations for a variable number of nodes are compressed, in particular to a predefined size that can be processed further. Thus, an independence of the number of input nodes, which may vary, is achieved. A further advantage of the pooling is that a focus can be made on encoded information that is of particular interest and which might-due to encoding also information of distant nodes otherwise be disregarded.

An advantageous pooling algorithm is to consider only maximum entries in a certain area, e.g. a row or line or sub-matrix, i.e. a matrix having lower dimension than the complete matrix, e.g. a 2x2 matrix out of a 16x16 matrix. This allows to focus on the most prominent values which often have the largest influence on relations between components.

According to an embodiment a pooling algorithm is used that

$$\mathbf{r}_i = \max_{n=1}^{N_i} \mathbf{x}_n$$

Where x is a vector of the concatenated data matrix and r is the representation resulting from the pooling P, which is referred to in Fig.2 as pooled data PD. i is the number of dimensions pooled data PD can assume. $N_i$ is the number of rows of the concatenated data. Thus, by the pooled data PD a representation is obtained that is independent of the original number of nodes, which depends on the technical system to be investigated and on what or which indicator in the technical system is of interest.

In this embodiment a maximum pooling considering only the maximum value is done. Alternatively, other pooling methods such as taking a mean value or the sum of the regarded entries can be taken.

The pooled data PD are combined, e.g. concatenated, with the numerical attributes ATT, thus obtaining the pooled graph encoded data PGED, which are according to an advantageous embodiment represented as a vector, which can be regarded as vector representation of a specific design.

Thus, the pooled graph encoded data encode the data architecture DA contained in the graph up to the desired order correlations and the attributes assigned to nodes.

Combining numerical attributes ATT of the nodes at this stage lead according to experiments to a better approximation of the indicators.

The pooled data PD cannot be directly interpreted, i.e. do not show directly e.g. a physical or technical or chemical meaning. What is done in step D is to extract a useful indicator from the pooled graph encoded data PGED which comprise these pooled data PD. Therefore, the multi-dimensional encoded information is transformed to e.g. a continuous numeric output or vector, w. For this a so called "dense layer" is used which can be regarded as a "feed forward neural network" or multilayer perceptron.

In step D the pooled graph encoded data PGED are used as input for dense layers DL. The dense layer can be realized by a multilayer perceptron and reduces the number of dimension of the pooled graph encoded data PGED such that a vector denoting the searched indicator KPI is achieved.

According to advantageous embodiment for the dense layers the following activation function is used:

$$y = Relu\left(X_{pool} \cdot W_h\right) \cdot W_{out}$$

wherein y is the output of the dense layers, hence the sought for indicator, e.g. the acceleration versus fuel consummation. $X_{pool}$ is the graph encoded pooled data PGED.

$W_h$ is the weight of layer h or in other words the set of parameters or weights of the connections or edges used in a hidden layer of a neural network for the edges from one layer to the node of another layer. An entry of this vector can be the weight of an edge leading from a node in layer h to another node in a different layer. W

$W_{out}$ is the weight of the output layer, i.e. describes the weights of the edges leading from the last hidden layer to the output layer $W_{out}$ and $W_{in}$ are both learned in the machine learning process.

Relu (rectified linear unit) is an activation function for the dense layers, which is used in an embodiment and performs well for the described example where KPIs are derived for hybrid car architecture.

This neural network comprising at least one convolutional layer, optionally a pooling layer and a dense layer is trained with data generated in a simulation environment or obtained from real experiments.

The simulation environment is advantageous to generate sufficient training data to train the neural network. Training data can be created by generating a large number (1000s) of designs randomly sampled from the design space. These designs need to be simulated by the simulation environment in order to identify the relevant KPIs. This set of designs and corresponding KPIs then forms the basis for the training set that is used to train the neural network. Assuming there is some form of smoothness, regularity or structure in the design space, the neural network is able to generalize to unseen designs and approximate their KPIs well, i.e. the machine learning applies an inductive learning algorithm on the graph structured data. This is an advantage in comparison to most algorithms which function only transductively.

Once the neural network is trained, the simulation environment is no longer necessary as the neural network can provide predictions without it. Thus, once the neural network is trained with these simulation data, new data can be obtained in much less time than the simulation requires.

The described neural network may can be one single neural network with at least one graph convolutional neural network, one or more pooling layers and dense layers. Alternatively, an architecture of several neural networks is used, comprising a graph neural network with a convolutional layer, at least a second graph neural network, a neural network containing a pooling layer and a multilayer perceptron as dense layer.

Fig. 4

In Fig. 4 an embodiment of an apparatus is shown by which the described method can be performed: The determination unit DU is used for determining an indicator describing a performance of at least some components of the technical system HV describing the hybrid car.

In a graphical description unit GDU a data architecture graph of a technical system HV is obtained. As described before, the data architecture graph has nodes connected by edges, said nodes representing components or group of components, or properties of components or group of components of the technical system.

The edges represent relations between components or properties of components of the technical system. Further, there is a simulation Unit GCNN for computing by use of a graphic convolutional neural network encoded data from the data architecture graph. For the encoded data relations between directly neighbored nodes are encoded and by re-iteration further encoded data encoding relations between not directly neighbored nodes are obtained.

In a concatenation unit CU for encoded and further encoded data are concatenated. A pooling unit PU is used for compressing the obtained concatenated representation preferably to a predefined size. In a graph encoding unit GEU the compressed concatenated representation is combined with at least one numerical attribute. In the prediction Unit PDU the representation from the graph encoding unit GEU is transformed to the indicator by using a dense layer DL neural network.

A construction system for the construction of a complex system such as a car or a production line may comprise one or more such determination units DU or apply a method as described in relation with Fig. 2.

Although the present invention has been described in accordance with preferred embodiments or aspects thereof, it is obvious for the person skilled in the art that modifications or combination between the embodiments, fully or in one or more aspects, are possible in all embodiments.

Parts of the description have been presented in terms of operations performed by a computer system, using terms such as data and the like, consistent with the manner commonly employed by those skilled in the art to convey the substance of their work to others skilled in the art. As is well understood by those skilled in the art, these quantities take the form of electrical, magnetic, or optical signals capable of being stored, transferred, combined, and otherwise manipulated through mechanical and electrical components of the computer system; and the term computer system includes general purpose as well as special purpose data processing machines, routers, bridges, switches, and the like, that are standalone, adjunct or embedded.

Additionally, various operations will be described as multiple discrete steps in turn in a manner that is helpful to understand the present invention. However, the order of description should not be construed as to imply that these operations are necessarily order dependent, in particular, the order of their presentation.

Reference in the specification to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

**Claims**

1. Method for determining an indicator (KPI) describing a performance of at least some components of a technical system (HV),
   said components having properties that enable a relation between two or more components,
   whereby to at least some of the components an attribute (ATT) is assigned,
   said method having the following steps:

   a) Representing (A) the technical system (HV) by a data architecture graph (DA) having nodes connected by edges, said nodes representing components or group of components, or properties of components or group of components of the technical system, and
   said edges representing relations between components or properties of components of the technical system (HV) ;
   b) Using (B) the data architecture graph (DA) as input for a first graph convolutional neural network (GCNN1) in order to create encoded data ($H^{(1)}$) in which a relation between nodes that are directly connected by an edge is encoded, said first graph convolutional neural network (GCNN1) being trained by a machine learning model operating on the data architecture graph;
   c) Combining (C) the encoded data with at least some of the attributes (ATT) by which pooled graph encoded data (PGED) are obtained;
   d) Predict (D) the indicator (KPI) by using these combined data as input for a dense layer neural network (DL) .

2. Method according to claim 1 with the

   b1) using the encoded data ($H^{(1)}$) obtained in step b) as output from the first graph neural network (CGNN1) as input data for a further graph convolutional neural network (CGNN2) by which further encoded data ($H^{(2)}$) are obtained;
   b2) concatenate encoded data ($H^{(1)}$) and further encoded data ($H^{(2)}$) by which concatenated data (CC) are obtained, said concatenating being performed before the combining (C) with the attributes.

3. Method according to any of the previous claims wherein the attributes are numerical or categorical.

4. Method according to any of the previous claims wherein on the concatenated encoded data (CC) a pooling step (P) is performed before the combining (C) with at least one of the attributes (ATT),
   whereby in said pooling step (P) pooled data are obtained, whereby the size of the concatenated data (CC) is adapted to a predefined size.

5. Method according to any of the previous claims wherein
   a node is described by a type denoting the type of the component or/and
   a port describing a property that enables the relation between two or more components or/and
   an attribute.

6. Method according to any of the previous claims wherein the property that enables the relation is the enablement of an electrical or mechanical or electromagnetic or chemical or any other interaction.

7. Method according to any of the previous claims wherein the representation of the data architecture as graph and the machine learning model operating on the data architecture graph (DA) is permutation invariant.

8. Method according to claim 2, wherein step b1) is reiterated n times such that the output $H^{(1)}$ of previous graph neural network is used as input for a subsequent graph neural network $H^{(l+1)}$.

9. Method according to any of the previous claims wherein in step b or/and step b1) the data architecture graph (DA) is used as input data for the graph convolutional neural network (CGNN1, CGNN2), in which from the input data by use of a convolutional operator for each node a representation is obtained containing information about the relation of one node and at least some neighbored nodes.

10. Method according to any of the previous claims, wherein for step d) in the dense layers neural network (DL) as rectifier function a linear rectifier function is used which uses the pooled graph encoded data (PGED) as input data.

11. Determination unit (DU) for determining an indicator describing a performance of at least some components of a technical system (HV),
    said components having properties that enable a relation between two or more components,
    whereby to at least some of the components an attribute (ATT) is assigned, comprising the following:

a) Graphical description unit (GDU) for obtaining a data architecture graph of a technical system(HV), said data architecture graph having nodes connected by edges, said nodes representing components or group of components, or properties of components or group of components of the technical system, and said edges representing relations between components or properties of components of the technical system;

b) Simulation unit (GCNN) for computing by use of a graph convolutional neural network encoded data from the data architecture graph, in which in said encoded data relations between directly neighbored nodes are encoded and by re-iteration further encoded data encoding relations between not directly neighbored nodes are obtained, said graph convolutional neural network being trained by a machine learning model operating on the data architecture graph;

c) Concatenation unit (CU) for concatenating encoded and further encoded data;

d) Pooling unit (PU) for compressing the obtained concatenated representation;

e) Graph encoding unit (GEU) for combining the compressed concatenated representation with at least one, in particular numerical, attribute and

f) prediction unit(PDU) to transform the representation from the graph encoding unit (GEU) to the indicator by using a dense layer (DL) neural network.

12. Construction system for a product or a part thereof, the product comprising at least two components, at least one component having at least one component attribute, said construction system considering at least one indicator derived from a method according to any of the previous claims 1 to 10.

13. Construction system for a product or a part thereof, the product comprising at least two components, at least one component having at least one component attribute, said construction system comprising a determination unit according to claim 11.

14. Computer program product for performing a method according to any of the claims 1 to 10.

15. Computer readable storage media with a computer program product according to the previous claim 14.

# FIG 1a

# FIG 1b

| F1 | F2 | F3 | F4 |
|-----|-----|-----|-----|
| 1.2 | 50 | 90 | 0 |
| 2.2 | 10 | 0 | 35 |
| 1.0 | 0 | 40 | 90 |
| 1.8 | 30 | 0 | 45 |

FIG 2

## FIG 3a

## FIG 3b

## FIG 4

DU

GDU  GCNN  CU  PU  GEU  PDU

Europäisches
Patentamt

European
Patent Office

Office européen
des brevets

# EUROPEAN SEARCH REPORT

Application Number

EP 20 19 1767

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KOROLEV VADIM ET AL: "Graph Convolutional Neural Networks as "General-Purpose" Property Predictors: The Universality and Limits of Applicability", JOURNAL OF CHEMICAL INFORMATION AND MODELING, [Online] vol. 60, no. 1, 20 December 2019 (2019-12-20), pages 22-28, XP055775205, US ISSN: 1549-9596, DOI: 10.1021/acs.jcim.9b00587 Retrieved from the Internet: URL:https://pubs.acs.org/doi/pdf/10.1021/acs.jcim.9b00587> [retrieved on 2021-02-11] * Abstract; Figure 2 * | 1-15 | INV. G06N3/04 G06F30/27 G06N3/08 G06N5/02 ADD. B60K6/00 |
| A | JIANG WAN ET AL: "Future Automation Engineering using Structural Graph Convolutional Neural Networks", ARXIV.ORG, CORNELL UNIVERSITY LIBRARY, 201 OLIN LIBRARY CORNELL UNIVERSITY ITHACA, NY 14853, 24 August 2018 (2018-08-24), XP081176636, DOI: 10.1145/3240765.3243477 * the whole document * | 1-15 | |
| A | REN HAOXING ET AL: "ParaGraph: Layout Parasitics and Device Parameter Prediction using Graph Neural Networks", 2020 57TH ACM/IEEE DESIGN AUTOMATION CONFERENCE (DAC), IEEE, 20 July 2020 (2020-07-20), pages 1-6, XP033838023, DOI: 10.1109/DAC18072.2020.9218515 [retrieved on 2020-10-08] * Sections II and III * | 1-15 | TECHNICAL FIELDS SEARCHED (IPC) G06N B60K G06F |

The present search report has been drawn up for all claims

| Place of search | Date of completion of the search | Examiner |
|---|---|---|
| The Hague | 12 February 2021 | Szymanski, Francois |

EPO FORM 1503 03.82 (P04C01)